# EUROPÄISCHE PATENTSCHRIFT

(11) **EP 3 485 634 B1**
(45) Veröffentlichungstag und Bekanntmachung des Hinweises auf die Patenterteilung: **16.09.2020**
(21) Anmeldenummer: 17754265.1
(22) Anmeldetag: 10.07.2017
(51) Int. Cl.: H04N 5/378, H04N 5/347, H04N 9/04, H04N 5/369

(54) **LICHTSENSORMODUL UND VERFAHREN ZUM BETREIBEN EINES LICHTSENSORMODULS**
LIGHT-SENSOR MODULE AND METHOD FOR OPERATING A LIGHT-SENSOR MODULE
MODULE DE DÉTECTION DE LUMIÈRE ET PROCÉDÉ PERMETTANT DE FAIRE FONCTIONNER UN MODULE DE DÉTECTION DE LUMIÈRE

(30) Priorität: 13.07.2016 DE 102016212797
(43) Veröffentlichungstag der Anmeldung: 22.05.2019
(73) Patentinhaber: Robert Bosch GmbH, 70442 Stuttgart (DE)
(72) Erfinder: SEGER, Ulrich, 71229 Leonberg-Warmbronn (DE); GEESE, Marc, 73760 Ostfildern-Kemnat (DE)
(86) Internationale Anmeldenummer: PCT/EP2017/067223
(87) Internationale Veröffentlichungsnummer: WO 2018/011123

(56) Entgegenhaltungen:
- EP-A1- 3 026 892
- WO-A1-2014/203844
- CN-A- 104 241 310
- US-A1- 2011 156 197
- US-A1- 2011 285 713
- US-A1- 2012 307 120
- US-A1- 2015 350 575

## Beschreibung

### Stand der Technik

Die Erfindung geht aus von einer Vorrichtung oder einem Verfahren nach Gattung der unabhängigen Ansprüche. Gegenstand der vorliegenden Erfindung ist auch ein Computerprogramm.

Ein Lichtsensormodul kann als ein Sensorarray aus einer Mehrzahl mehrkanaliger Makrozellen realisiert sein.

Die US 2015/350575 A1 befasst sich mit einer Pixeleinteilung in einem Bildsensor. Die US 2012/307120 A1 befasst sich mit einem Pixelfeld, wobei Einheiten von Pixeln gleichzeitig ausgelesen werden können. Die EP 3 026 892 A1 befasst sich mit einem RGBC Farbfilterfeld mit unterschiedlich großen Feldern. Die US 2011/285713 A1 befasst sich mit einem Verfahren zum. Verarbeiten von Sub-Pixeln. Dabei werden Pixel unterschiedlicher Größen verwendet. Die WO 2014/203844 A1 befasst sich mit einem Bildeingabegerät. Die US 2011 /156197 A1 befasst sich mit einem Bildsensor mit einem Sensorchip und einem damit elektrisch verbundenen Schaltungschip. Die CN 104 241310 A befasst sich mit einem CMOS-Bildpixelarray mit einer Zweilinsenschicht.

### Offenbarung der Erfindung

Vor diesem Hintergrund werden mit dem hier vorgestellten Ansatz ein Lichtsensormodul, ein Verfahren zum Betreiben eines Lichtsensormoduls sowie schließlich ein entsprechendes Computerprogramm gemäß den Hauptansprüchen vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Unter einer Sensorlage kann beispielsweise eine Schicht aus einem Halbleitermaterial verstanden werden oder eine Hybridschicht aus organischen und Halbleitermaterialien. Unter einer Sensorzelle kann etwa eine fünfkanalige, lichtempfindliche Makrozelle verstanden werden, auch Makropixel genannt. Unter einem Sensorpixel kann ein Einzelelement der Sensorzelle verstanden werden. Beispielsweise können die Sensorzellen je ein größeres Hauptpixel und vier kleinere Zusatzpixel aufweisen. Die Zusatzpixel sind symmetrisch um das Hauptpixel herum angeordnet. Daher können die Zusatzpixel auch als Satellitenzellen bezeichnet werden. Gemäß einer Ausführungsform werden die Sensorpixel auch als Sensorzellen bezeichnet. Unter einer Lichteigenschaft kann beispielsweise eine Wellenlänge oder Farbe, eine Polarisation oder ein zeitlicher Intensitätsverlauf verstanden werden Unter der Wandelcharakteristik kann eine lineare oder logarithmische Umsetzung des Intensitätssignals in ein elektrisches Signal verstanden werden.

Der hier vorgestellte Ansatz beruht auf der Erkenntnis, dass durch zeilenweises Auswählen und spaltenweises Auslesen von Sensorpixeln eines Lichtsensormoduls, etwa einer Sensorarrayanordnung für maschinelles Sehen, eine Datenrate zum Generieren eines Bildsignals trotz hoher Auflösung deutlich reduziert werden kann. Dadurch, dass die einzelnen Sensorpixel jeweils unterschiedliche Lichteigenschaften erfassen, kann zudem die Erkennungsgenauigkeit des Lichtsensormoduls erhöht werden.

Die messbaren Lichteigenschaften spiegeln die Wechselwirkung einer Beleuchtung mit den Oberflächen von Objekten in der Umgebung wider. Insbesondere Polarisations- und Farberscheinungen, aber auch eine Intensitätsmodulation aufgrund der zunehmend auftretenden gepulsten Belichtungsquellen stellen zur Klassifikation von Objekten besonders geeignete Charakteristiken dar.

Besonders vorteilhaft ist es daher, diese Charakteristiken mittels eines geeigneten Lichtsensormoduls, wie es Gegenstand des hier beschriebenen Ansatzes ist, ortsgleich mit weiteren Merkmalen zu erfassen, um damit die Gesamtheit verschiedener Merkmale eines Objekts mit ebendiesem Objekt verknüpfen zu können und die Erkennung von Situationen, etwa eine modulierte Beleuchtung, eine nasse Fahrbahn oder eine reflektierende Gebäudefassade, oder auch die Differenzierung von Objekten von ihrem jeweiligen Hintergrund durch Vergleich von Objektmerkmalen wie etwa einer breitbandigen Reflektanz, einer spektralen Zusammensetzung einer Reflexion oder einer Polarisation zu vereinfachen.

Eine Fläche des Hauptpixels ist größer als eine jeweilige Fläche eines Zusatzpixels. Dadurch kann die Effizienz des Lichtsensormoduls erhöht werden. Es ist auch denkbar, dass die größere Fläche des Hauptpixels durch eine Zusammenschaltung mehrerer Sensorpixel der gleichen Art erfolgt, welche bspw. die gleiche Lichteigenschaft aufweisen. Die einzelnen Sensorpixel fungieren in diesem Zusammenschluss dann als ein großes Sensorpixel und werden auch gemeinsam angesteuert und ausgelesen. Die Form der Sensorpixel kann hierbei beliebig gewählt werden, beispielsweise als Rechteckt, Kreis oder als Kreuz.

Die Zusatzpixel sind symmetrisch um das Hauptpixel angeordnet. Dadurch wird eine gleichmäßige Anordnung der Sensorpixel in der Sensorlage ermöglicht.

Gemäß einer weiteren Ausführungsform kann das Hauptpixel als ein die Sensorzelle in vier Quadranten aufteilendes Kreuz ausgeformt sein. Hierbei kann in jedem der vier Quadranten je eines der in diesem Fall vier Zusatzpixel angeordnet sein. Dadurch kann die Sensorzelle möglichst platzsparend realisiert werden.

Es ist vorteilhaft, wenn das Hauptpixel ausgebildet ist, um eine Helligkeit, insbesondere eine breitbandige Helligkeit zu erfassen. Dadurch wird eine besonders empfindliche Helligkeitserfassung mittels des Lichtsensormoduls ermöglicht.

Das Lichtsensormodul kann eine Signalverarbeitungslage aufweisen. Hierbei kann die Signalverarbeitungseinheit in der Signalverarbeitungslage angeordnet sein. Die Signalverarbeitungslage und die Sensorlage können in einem Verfahren der Halbleitertechnik ("stapeln" oder "hybrid bonden") zu einem, beispielsweise mechanisch und elektrisch gekoppelten, Lagenverbund miteinander kombiniert sein. Dadurch kann das Lichtsensormodul effizient und kostengünstig miniaturisiert werden.

Die Sensorpixel können in zumindest einer ersten Zeile und einer zweiten Zeile angeordnet sein. Die erste Zeile kann eine größere Anzahl von über die Auswahlleitung auswählbarer Sensorpixel als die zweite Zeile aufweisen.

Zusätzlich oder alternativ können die Sensorpixel in zumindest einer ersten Spalte und einer zweiten Spalte angeordnet sein. Hierbei kann die erste Spalte eine größere Anzahl von über die Leseleitung auslesbarer Sensorpixel als die zweite Spalte aufweisen. Dadurch wird eine flexible Anordnung der Sensorpixel in der Sensorlage ermöglicht.

Der hier beschriebene Ansatz schafft zudem ein Verfahren zum Betreiben eines Lichtsensormoduls gemäß einer der vorstehenden Ausführungsformen, wobei das Verfahren folgende Schritte umfasst:
Zeilenweises Auswählen von Sensorpixeln über die Auswahlleitung; und
Auslesen von Sensorsignalen der über die Auswahlleitung ausgewählten Sensorpixel über die Leseleitung.

Gemäß einer Ausführungsform werden im Schritt des Auslesens die Sensorsignale der Sensorzellen im Wesentlichen zeitgleich ausgelesen.

Diese Ausführungsform bietet den Vorteil, dass das Auslesen der Sensorsignale einer Sensorzelle ohne eine aufwändige Zwischenspeicherung der Sensorsignale erfolgen kann. Hierdurch sind keine separaten Speicherelemente oder unnötige Rechenkapazitäten notwendig. Die Auslesung einer gesamten Sensorzeile, welche wiederum mehrere Sensorzellen enthält kann entweder zeitversetzt oder annähernd zeitgleich erfolgen. Je nach gewählter Ansteuerung / Verschaltung des Bildsensors. Die Zusammenfassung der Signale der Einzelzellen kann entweder in der analogen Domäne durch Zusammenschaltung von Leseleitungen in einem Summationspunkt, kapazitive Kopplung auf einer geschalteten Kapazität o.ä. erfolgen. Dabei ist auch eine gewichtete Zusammenschaltung durch Einführung steuerbarer Verstärkungs- oder Offsetglieder möglich. Ebenso kann die Zusammenfassung der Signale nach der AD-Wandlung durch ein Rechenwerk (für Akkumulation, Division, Multiplikation) durchgeführt werden. Unter im Wesentlichen zeitgleich ist hiermit gemeint, dass selbstverständlich auch kleine zeitliche Offsets möglich sind, die beim Auslesen / Abtasten von einzelnen Sensorsignalen entstehen und dem Fachmann bekannt sind.

Zudem ist eine Ausführungsform denkbar, bei welcher mehrere Zeilen gleichzeitig adressiert und die Sensorpixel einer Sensorzelle zeitgleich ausgelesen werden, insbesondere können 3 oder 5 Zeilen des Bildsensors gleichzeitig adressiert werden. Hierdurch kann ebenfalls eine Zwischenspeicherung entfallen.

Gemäß einer weiteren Ausführungsform kann das Verfahren einen Schritt des Generierens eines Bildsignals unter Verwendung der Sensorsignale umfassen. Insbesondere kann hierbei das Bildsignal ohne Zwischenspeicherung der Sensorsignale generiert werden. Dadurch kann das Bildsignal besonders effizient generiert werden.

Gemäß einer weiteren Ausführungsform des Verfahrens werden definierte Pixelgruppen und/oder Zellenkombinationen zeitversetzt ausgelesen. Hierbei kann der gesamte Bildsensor bzw. alle verfügbaren Sensorpixel beispielsweise in zwei oder mehrere Pixelgruppen oder Zellkombinationen aufgeteilt werden. Von Vorteil ist es, wenn die Pixelgruppen oder Zellgruppen eine gleiche Eigenschaft der detektierten Strahlung erfassen können, bspw. einen Luminanzwert und/oder Chrominanzwer. Dies ist durch eine entsprechende Auswahl der einzelnen Sensorpixel umsetzbar. Der Zeitversatz zwischen dem Auslesen der unterschiedlichen Pixelgruppen und/oder Zellenkombinationen kann unabhängig von der Auslesefrequenz des Bildsensors gewählt werden. Der Wert kann beliebig groß sein und während des Betriebs des Bildsensors verändert werden. Hierfür kann eine separate Einheit vorgesehen sein.

Diese Verfahren können beispielsweise in Software oder Hardware oder in einer Mischform aus Software und Hardware, bevorzugt in der Verarbeitungslage des Sensormoduls, implementiert sein. Die Verarbeitung erfolgt in erster Linie zu dem Zweck die Information zu verdichten und den Übertragungskanal zu einem Steuergerät zu entlasten, deshalb werden die Daten gemäß einer Ausführungsform im Verbund mit der Sensor-Schicht verarbeitet werden.

Der hier vorgestellte Ansatz schafft ferner eine Vorrichtung, die ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form einer Vorrichtung kann die der Erfindung zugrunde liegende Aufgabe schnell und effizient gelöst werden.

Hierzu kann die Vorrichtung zumindest eine Recheneinheit zum Verarbeiten von Signalen oder Daten, zumindest eine Speichereinheit zum Speichern von Signalen oder Daten, zumindest eine Schnittstelle zu einem Sensor oder einem Aktor zum Einlesen von Sensorsignalen von dem Sensor oder zum Ausgeben von Daten- oder Steuersignalen an den Aktor und/oder zumindest eine Kommunikationsschnittstelle zum Einlesen oder Ausgeben von Daten aufweisen, die in ein Kommunikationsprotokoll eingebettet sind. Die Recheneinheit kann beispielsweise ein Signalprozessor, ein Mikrocontroller oder dergleichen sein, wobei die Speichereinheit ein Flash-Speicher, ein EPROM oder eine magnetische Speichereinheit sein kann. Die Kommunikationsschnittstelle kann ausgebildet sein, um Daten drahtlos und/oder leitungsgebunden einzulesen oder auszugeben, wobei eine Kommunikationsschnittstelle, die leitungsgebundene

Daten einlesen oder ausgeben kann, diese Daten beispielsweise elektrisch oder optisch aus einer entsprechenden Datenübertragungsleitung einlesen oder in eine entsprechende Datenübertragungsleitung ausgeben kann.

Unter einer Vorrichtung kann vorliegend ein elektrisches Gerät verstanden werden, das Sensorsignale verarbeitet und in Abhängigkeit davon Steuer-und/oder Datensignale ausgibt. Die Vorrichtung kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Vorrichtung beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Gemäß einer Ausführungsform findet in dem Sensormodul (= Verbund von Sensorlage und Signalverarbeitungslage) eine Informationsverdichtung statt. Diese wird typischerweise mit einem µC, DSP oder einem programmierbaren, trainierbaren oder selbstlernenden neuronalen Netzwerk erreicht. Die für die Verdichtung vorgesehenen Elemente oder Bauteile werden auch Verknüpfungsnetzwerke genannt. Die Datenmenge wir reduziert, und einige Merkmale (z.B. die Polarisation) codiert zu übertragen. Damit können die Verfahrenschritte auch mit der Software auf einen angeschlossenen System-Rechner verteilt werden.

Ausführungsbeispiele der Erfindung sind in den Zeichnungen dargestellt und in der nachfolgenden Beschreibung näher erläutert. Es zeigt:
Fig. 1 eine schematische Darstellung von zur korrekten Rekonstruktion erforderlichen Abtastwerten in einem Array;
Fig. 2 eine schematische Darstellung einer für die korrekte Signalrekonstruktion minimal erforderlichen Makrozelle in dem Array aus Fig. 1;
Fig. 3 eine schematische Darstellung eines Lichtsensormoduls gemäß einem erfindungsgemäßen Ausführungsbeispiel;
Fig. 4 eine schematische Darstellung einer exemplarischen Signalverarbeitungskette in einem Lichtsensormodul gemäß einem Ausführungsbeispiel;
Fig. 5 eine schematische Darstellung eines Querschnitts durch ein Lichtsensormodul gemäß einem Ausführungsbeispiel;
Fig. 6 eine schematische Darstellung einer Makro-Sensorzelle aus Fig. 3;
Fig. 7 eine schematische Darstellung einer Super-Sensorzelle gemäß einem Ausführungsbeispiel;
Fig. 8 eine schematische Darstellung eines Lichtsensormoduls gemäß einem Ausführungsbeispiel;
Fig. 9 eine schematische Darstellung einer adressierten Makrozelle gemäß einem Ausführungsbeispiel;
Fig. 10 eine schematische Darstellung einer adressierten Superzelle gemäß einem Ausführungsbeispiel;
Fig. 11 eine schematische Darstellung eines Adressierungsschemas für die zeitgleiche Adressierung einer Superzelle gemäß einem Ausführungsbeispiel;
Fig. 12 eine schematische Darstellung eines Adressierungsschemas für eine Adressierung einer Superzelle mit überlappender Adressierung der Satellitenzellen gemäß einem Ausführungsbeispiel;
Fig. 13 eine schematische Darstellung eines Lichtsensormoduls gemäß einem Ausführungsbeispiel;
Fig. 14 ein Ablaufdiagramm eines Verfahrens zum Betreiben eines Lichtsensormoduls gemäß einem Ausführungsbeispiel;
Fig. 15 eine schematische Darstellung einer Vorrichtung gemäß einem Ausführungsbeispiel;
Fig. 16 ein Ablaufdiagramm eines Verfahrens zum Herstellen eines Lichtsensormoduls gemäß einem Ausführungsbeispiel;
Fig. 17 eine schematische Darstellung eines minimalen Filterkerns in einem regelmäßigen 4-kanaligen Array; und
Fig. 18 eine schematische Darstellung eines minimalen Unschärfekreises.
Fig. 19 ein Ausleseschema des Lichtsensormoduls.
Fig. 20 ein weiteres Ausleseschema des Lichtsensormoduls.
Fig. 21 ein weiteres Ausleseschema des Lichtsensormoduls.
Fig. 22 ein weiteres Ausleseschema des Lichtsensormoduls.
Fig. 23 ein weiteres Ausleseschema des Lichtsensormoduls.
Fig. 24 einen schematischen Aufbau einer Lichtsensormodulbaugruppe.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

Typischerweise bestehen moderne Bildsensoren aus einem orthogonalen Gitter an Einzelsensorzellen, die je nach Anwendung mit oder ohne Color-Filter-Array, kurz CFA, zur Separation unterschiedlicher Spektralkanäle ausgestattet sind.

Ausnahme sind dreidimensional integrierte Sensoren, die vertikal angeordnete Empfängerelemente aufweisen, nach dem Hersteller der Anordnung auch auch "Foveon"-like structure genannt.

Für die Rekonstruktion eines abgetasteten Signals ist die Bewertung mehrerer Abtastpunkte erforderlich.

In einem Standardfarbsensor wird üblicherweise eine Makrozelle aus n Elementarzellen gebildet, die repetitiv in einem Array angeordnet werden. Die Anzahl n der Kanäle dieser Makrozelle legt die maximale Anzahl der unterschiedlichen Lichteigenschaften fest, die abgetastet werden können.

Da die typische Array-Form das orthogonale Gitter ist, werden bei einer ungeraden Anzahl von Lichteigenschaften eines oder mehrere Elemente verdoppelt.

Für ein Standard-Bayer-Pattern sind die Kanäle 1 bis 4 beispielsweise wie folgt belegt:
1 = Rot
2 = Grün
3 = Grün
4 = Blau

Weitere bekannte Farbsysteme sind:
1 = Cyan
2 = Yellow
3 = Yellow
4 = Magenta

Oder:
1 = Red
2 = Clear (spektral breitbandig geöffneter Passfilter)
3 = NIR (nahes Infrarot)
4 = Green

Um eine Abtastung zu erzeugen, die eine verlustfreie Rekonstruktion des kontinuierlichen Originalsignals erlaubt, sollten in jede Abtastraumrichtung mindestens zwei Abtastpunkte pro abgetasteter Eigenschaft einbezogen werden.

Der Abtastraum eines Sensorarrays erstreckt sich über die Ortsfrequenz in jede der zwei Array-Dimensionen und die Dimension Zeit.

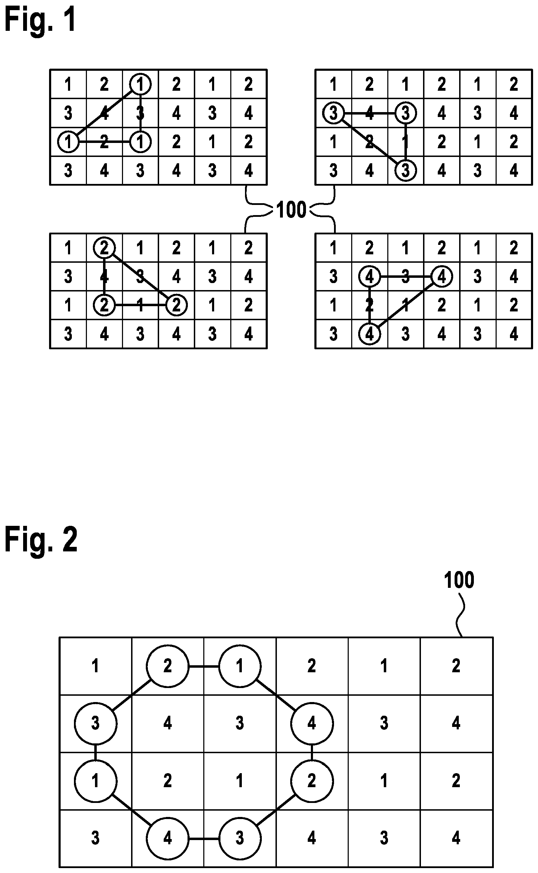

Die minimale abtastbare Ortsfrequenz ist also das Doppelte des minimalen Abstands zweier Zellen, die die gleiche Signalgröße abtasten, in Fig. 1 beispielsweise Zellen mit gleicher Nummer.

Fig. 1 zeigt eine schematische Darstellung von zur korrekten Rekonstruktion erforderlichen Abtastwerten in einem Array 100. Gezeigt sind verschiedene Elementardreiecke, die durch benachbarte Sensorzellen der gleichen Art aufgespannt werden.

Als größter Mittenabstand taucht zweimal der diagonale Pixelabstand auf. Damit ist die minimal verlustfrei zu rekonstruierende Ortsfrequenz in jedem der Kanäle durch das Vierfache des diagonalen Pixelabstands gegeben.

Fig. 2 zeigt eine schematische Darstellung einer für die korrekte Signalrekonstruktion minimal erforderlichen Makrozelle in dem Array aus Fig. 1.

Da die Bedingung für alle Lichteigenschaften gegeben sein sollte, ergibt sich bei einem orthogonalen Gitter die Form eines Oktagons, dessen Eckpunkte durch den Schwerpunkt von je zwei Elementarzellen pro Kanal besetzt sind. Dies ist in Fig. 2 veranschaulicht.

Bei der Auslegung der Sensoren gilt es, einen guten Kompromiss zwischen der Lichtempfindlichkeit, der räumlichen Auflösung, der Qualität der Messung von auf die Anwendung bezogenen relevanten Lichteigenschaften, der Übertragungsbandbreite und den Kosten zu finden.

Eine hohe Lichtempfindlichkeit wird bei gegebenem Prozess durch größere Sensorzellen erreicht. Die räumliche Auflösung kann durch vergrößerte Arrays, d. h. eine höhere Anzahl von Sensorzellen, erhöht werden. Die Messung relevanter Lichteigenschaften wie etwa Farbe oder Polarisationsrichtung wird durch eine möglichst feine, gut auf die Anwendung abgestimmte Zerlegung und Rekonstruktion der Lichteigenschaften erreicht. Die Übertragungsbandbreite wird im Wesentlichen durch die Anzahl der von dem Sensor zur Nachverarbeitung übertragenen Informationen bestimmt, typischerweise 12 Bit je Pixel. Die Kosten werden maßgeblich durch die Gesamtfläche des Sensors beeinflusst, jeweils bezogen auf ein bestimmtes Technologieniveau.

Der im Folgenden beschriebene Ansatz schafft nun eine Möglichkeit, bis zu fünf Lichtmerkmale in gleicher Auflösung abzutasten und über eine skalierbare Ansteuerung fallweise zugunsten einer höheren Rekonstruktionsqualität oder zugunsten einer höheren Auflösung zu verändern.

Eine optionale In-situ-Informationsverdichtung erlaubt es ferner, die Datenbandbreite am Ausgang auf die minimal notwendigen Maße zu reduzieren, da die Verdichtung der Daten von einem Pixelgitter auf ein dem Informationsgehalt angepasstes Informationsgitter transformiert wird.

Der im Folgenden beschriebene Ansatz erlaubt es beispielsweise, ein hochaufgelöstes Intensitäts- oder Grauwertbild mit einer ebenso hoch aufgelösten Messung der eingangs genannten Lichteigenschaften zu erzeugen. Um dies bei einer dedizierten optischen Auflösung, d. h. bei einem sich aus dem Design der Optik ergebenden Unschärfekreis, zu erreichen, ist es vorteilhaft, die Sensorpixel für jede zu erfassende Lichteigenschaft symmetrisch in einer Sensorzelle einzusetzen.

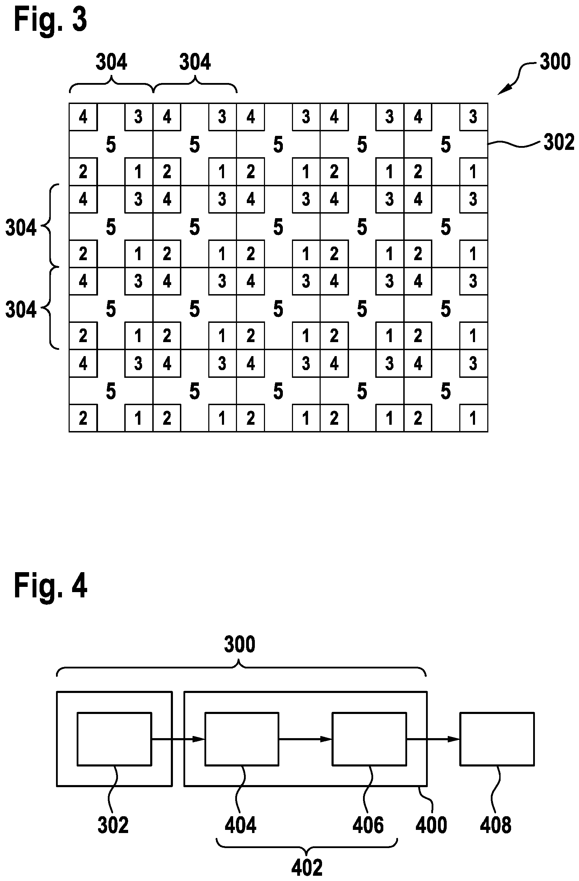

Fig. 3 zeigt eine schematische Darstellung eines Lichtsensormoduls 300 gemäß einem Ausführungsbeispiel. Das Lichtsensormodul 300 umfasst eine Sensorlage 302 mit einer Mehrzahl von Sensorzellen 304, die je fünf Sensorpixel 1, 2, 3, 4, 5 zum Erfassen je einer anderen Lichteigenschaft aufweisen. Die Sensorpixel 1, 2, 3, 4, 5 sind in Spalten und Zeilen über- bzw. nebeneinander angeordnet, wobei die Bezugszeichen 1 bis 5 je einen Messkanal repräsentieren. Fig. 3 zeigt eine Anordnung für eine fünfkanalige Abtastung. Gemäß einem Ausführungsbeispiel werden die Sensorpixel 1, 2, 3, 4, 5 auch als Sensorzellen bezeichnet.

Gemäß diesem Ausführungsbeispiel sind die Sensorpixel 5 als kreuzförmige Hauptpixel realisiert, die die Sensorzellen 304 jeweils in vier, hier im Wesentlichen gleich große Quadranten unterteilt. Die vier übrigen Sensorpixel 1, 2, 3, 4 sind jeweils als Zusatzpixel mit einer deutlich kleineren Sensorfläche als die Hauptpixel 5 realisiert. Jedes der Zusatzpixel 1, 2, 3, 4 ist in einem der Quadranten der Sensorzellen 304 angeordnet, sodass sich eine symmetrische Anordnung der Zusatzpixel 1, 2, 3, 4 um die Hauptpixel 5 ergibt. Beispielsweise sind die Hauptpixel 5 ausgebildet, um eine Helligkeit zu erfassen.

Die fünf Sensorpixel einer jeden Sensorzelle 304 sind je als ein anderer Lichtsensortyp ausgeführt.

Mögliche einsetzbare Sensortypen zur Erfassung der unterschiedlichen Lichteigenschaften sind beispielsweise für die Messung der Energie je Lichtfarbe (mehr als 10 Typen) sichtbare CFA für Cyan Magenta Yellow, R, G, B, Clear oder nicht sichtbare xFA für NIR, FIR, UV oder spezifische Bandpasseigenschaften (Chlorophyll-Kennlinien) und, für die Messung der Polarisation in vier Polarisationsfreiheitsgraden (siehe Stokes-Jones-Vektoren in zwei Implementierungen), Interferenzfilter (hor, vert, diag-left, diag-right) oder Wellenlängenmikrostrukturen (Metallgitter, TiOx Films usw.). Für die Erfassung der Intensität über einen "High Dynamic Range" mit mehreren Transfercharakteristiken eignen sich der Split-Pixel-Ansatz (große Diode und kleine Diode mit einem Knickpunkt), DCG-Pixel (dual or multiple convertion gain mit mehreren Knickpunkten) oder Log-Pixel (photovoltaic mode mit exakt logarithmischem Verhalten). Ein zeitlicher Intensitätsverlauf (zwei Implementierungsarten für zeitliche, von der Framezeit unabhängige Abtastungen) kann mittels Pulsed Light Measure Pixel (PWM-Gated Integration) oder Array Phase Shifted Readout Scheme (zeitliche Ableitung zeitlich verzögerter Abtastvorgänge benachbarter oder miteinander verwobener Zellen) erfolgen.

Aus der Permutation der oben genannten Möglichkeiten ergeben sich mehrere Tausend mögliche Variationen. Der hier vorgeschlagene Ansatz ermöglicht die Erfassung von fünf örtlichen und, bei geeigneter Ansteuerung, zwei zeitlichen Parametern.

Eine besonders vorteilhafte Auslesung von Makrozellen oder Superzellen erfolgt so, dass alle Sensorpixel der Makrozelle oder der Superzelle, bzw. deren Signale zeitgleich oder quasi zeitgleich ausgelesen werden. Diese Signale können in einer Rekonstruktionseinheit oder einem Verknüpfungsnetzwerk ohne Zwischenspeicherung weiterverarbeitet werden. Dadurch kann der Bedarf an Speicherkapazität für die Signalrekonstruktion signifikant verringert.

Um eine Zwischenspeicherung ganz oder teilweise zu umgehen, ist eine parallele Kommunikation zwischen Sensorarray und analoger oder digitaler Signalaufbereitungseinheit erforderlich.

Die gezeigte Anzahl von vier Zusatzpixeln 1, 2, 3, 4 ist dabei beispielhaft gewählt. Gemäß alternativer Ausführungsbeispiele kann zumindest ein Zusatzpixel 1, 2, 3, 4 und allgemein ausgedrückt, eine beliebige geeignete Anzahl von Zusatzpixeln 1, 2, 3, 4 verwendet werden.

Fig. 4 zeigt eine schematische Darstellung einer exemplarischen Signalverarbeitungskette in einem Lichtsensormodul 300 gemäß einem Ausführungsbeispiel. Gezeigt sind die Sensorlage 302, etwa ein Sensorarray aus n x m Elementarzellen, sowie eine Signalverarbeitungslage 400 mit einer Signalverarbeitungseinheit 402 aus einem ersten Block 404 zur analogen Signalverarbeitung und Analog-digital-Wandlung und einem zweiten Block 406 zur Sensorsignalverarbeitung auf i x k Elementen einer Makrozelle. In einem dritten Block 408 erfolgt die Bilddatenweiterverarbeitung außerhalb des Lichtsensormoduls 300. Die Signalverarbeitungseinrichtung 400, auch informationsverdichtende Einheit genannt, ist mit der Sensorlage 302 elektrisch leitfähig verbunden, wie nachfolgend näher beschrieben.

Eine Partitionierung wie in Fig. 4 angedeutet ist insbesondere in einer Stacked-Die-Technologie umsetzbar.

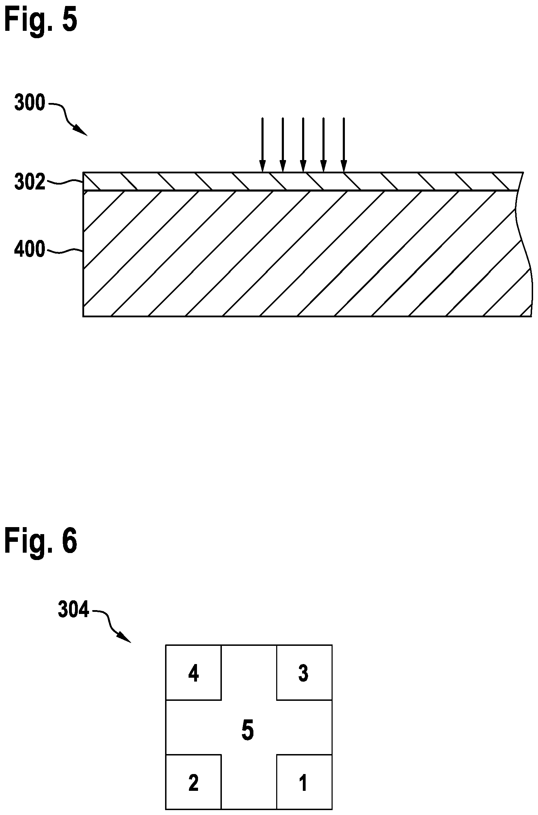

Fig. 5 zeigt eine schematische Darstellung eines Querschnitts durch ein Lichtsensormodul 300 gemäß einem Ausführungsbeispiel, etwa eines vorangehend anhand der Figuren 3 und 4 beschriebenen Lichtsensormoduls. Gezeigt sind die Sensorlage 302 und die Signalverarbeitungslage 400, die über ein Interface mit beispielsweise mehreren Tausend Verbindungen zu einem Lagenverbund miteinander kombiniert sind.

Die Verbindung zwischen beiden Schaltungsteilen in Form der Sensorlage 302 und der Signalverarbeitungslage 400 zur analogen und digitalen Signalaufbereitung erfolgt etwa durch Waferbonden. Insbesondere ist es vorteilhaft, wenn es mehrere Leseleitungen pro Arrayspalte gibt, die es erlauben, alle abgetasteten Lichteigenschaften, die entlang einer Spalte erfasst werden, auch getrennt zur Signalrekombinationseinheit in der Sensorsignalaufbereitung zu führen.

Fig. 6 zeigt eine schematische Darstellung einer Sensorzelle 304 aus Fig. 3. Die Sensorzelle 304 ist als eine minimale Fünf-Kanal-Makrozelle realisiert.

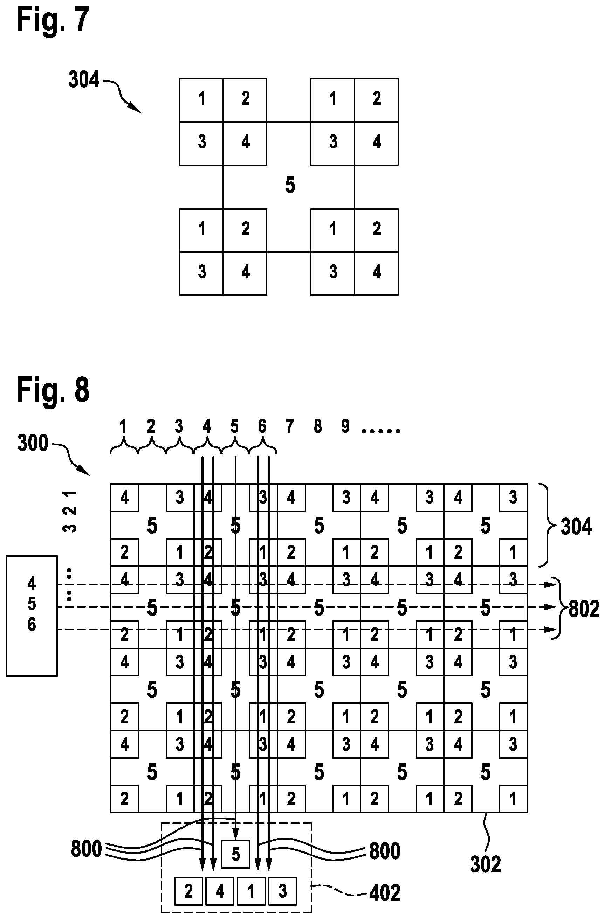

Fig. 7 zeigt eine schematische Darstellung einer Sensorzelle 304 gemäß einem Ausführungsbeispiel. Im Unterschied zu Fig. 6 ist die Sensorzelle 304 hier als eine optimale Fünf-Kanal-Makrozelle realisiert. Gezeigt sind zwei Zeilen mit n adressierbaren Elementen (3 und 4), eine Zeile mit n/2 adressierbaren Elementen (5) und zwei Zeilen mit n adressierbaren Elementen (1 und 2).

Durch geschickte Auslegung einer Ansteuerschaltung der Signalverarbeitungseinheit sind folgende vorteilhafte Adressierungsmodi möglich.

Gemäß einem Ausführungsbeispiel ist Kanal 5 als Luminanzkanal ausgelegt, wobei die Kanäle 1 bis 4 eine weitere Ermittlung der Luminanz ermöglichen, etwa aus der Kombination von drei Farbzellen mit einem Clear-Pixel oder von zwei Farbkanälen mit zwei Clear-Pixeln. Der zentrale Kanal 5 kann je nach Verteilung der Flächen in der Sensorzelle als fünf- bis zehnmal sensitiveres Sensorpixel ausgebildet sein. Gemäß einem Ausführungsbeispiel weist das Hauptpixel 5 eine etwa fünfmal größere Fläche als die in den Ecken platzierten Zusatzpixel auf.

Gemäß einem weiteren Ausführungsbeispiel sind die Zusatzpixel 1 bis 4 als Split-Pixel des Hauptpixels 5 ausgeführt, die beispielsweise nach getrennter Auslesung über eine Floating Diffusion mit dem Hauptpixel 5 umgeladen werden.

Das sich aus dieser analogen Zusammenschaltung ergebende Sensorsignal mittelt alle im Makropixel enthaltenen Signalladungen und ergibt darum ein besonders rauscharmes Signal.

Die Option der Zusammenschaltung kann beispielsweise genutzt werden, um bei schwachem Signal in den Zusatzpixeln 1 bis 4 die Verarbeitung einiger Lichtmerkmale zugunsten einer erhöhten Sensitivität aufzugeben.

Fig. 8 zeigt eine schematische Darstellung eines Lichtsensormoduls 300, etwa eines vorangehend anhand der Figuren 3 bis 7 beschriebenen Lichtsensormoduls. Gezeigt ist ein Adressierungsschema für eine Fünf-Kanal-Anordnung. Wie in Fig. 8 zu erkennen, sind die einzelnen Sensorpixel der Sensorzellen 304 in einer Mehrzahl nummerierter Zeilen und Spalten angeordnet. Hierbei sind die Sensorpixel einer jeden Spalte über zumindest eine einer jeweiligen Lichteigenschaft der Sensorpixel zugeordnete Leseleitung 800 elektrisch kontaktiert. Zur besseren Erkennbarkeit sind in Fig. 8 lediglich fünf

Leseleitungen 800 zum Auslesen der fünf Kanäle einer jeden der in einer Spalte übereinander angeordneten Sensorzellen 304 eingezeichnet.

Analog dazu sind die einzelnen Sensorpixel einer jeden Zeile über je eine Auswahlleitung 802 elektrisch kontaktiert. Die Auswahlleitungen 802 und die Leseleitungen 800 sind mit der Signalverarbeitungseinheit verbunden, die ausgebildet ist, um die Sensorpixel zeilenweise über die Auswahlleitungen 802 auszuwählen und die jeweiligen Sensorsignale der ausgewählten Sensorpixel über die entsprechenden Leseleitungen 800 auszulesen und zu verarbeiten.

Die Adressierung der minimalen Makrozellen erfolgt beispielsweise derart, dass eine unmittelbare Verarbeitung der Sensorsignale ohne Zwischenspeicherung erfolgt.

Beispielsweise werden die Auswahlleitungen 802 der Zeilen 4, 5, 6 durch die Signalverarbeitungseinheit zeitgleich selektiert, worauf alle adressierten Sensorzellen 304 (der Übersichtlichkeit halber ist in Fig. 8 nur ein Block von 3 Zeilen beispielhaft mit dem Bezugszeichen 304 bezeichnet) dieser Zeilen ihre jeweilige Leseleitung 800 treiben. Stehen pro ungerader Spalte zwei Leseleitungen 800 zur Verfügung, so werden über jeweils fünf Leseleitungen 800 die fünf Werte einer minimalen Makrozelle in die Signalverarbeitungseinheit transportiert und dort zu einer komplexen Bildpunktinformation zusammengefasst. So kann etwa aus fünf 12-Bit-Intensitätssignalen ein hochdynamischer, applikationsangepasster Signalwert mit 12-Bit-Luminanzsignal, 16-Bit-Farbsignal und 2-Bit-Modulations- oder Polarisationswert erzeugt werden. Dies hat den Vorteil eines höheren verwertbaren Signalinhalts bei geringerer Übertragungsbandbreite am Chipausgang.

Eine optionale Nachverarbeitungseinheit ist beispielsweise ausgebildet, um eine eigene Verstärkungseinstellung oder Offset/Gain-Korrektur pro Auslesekanal vorzunehmen.

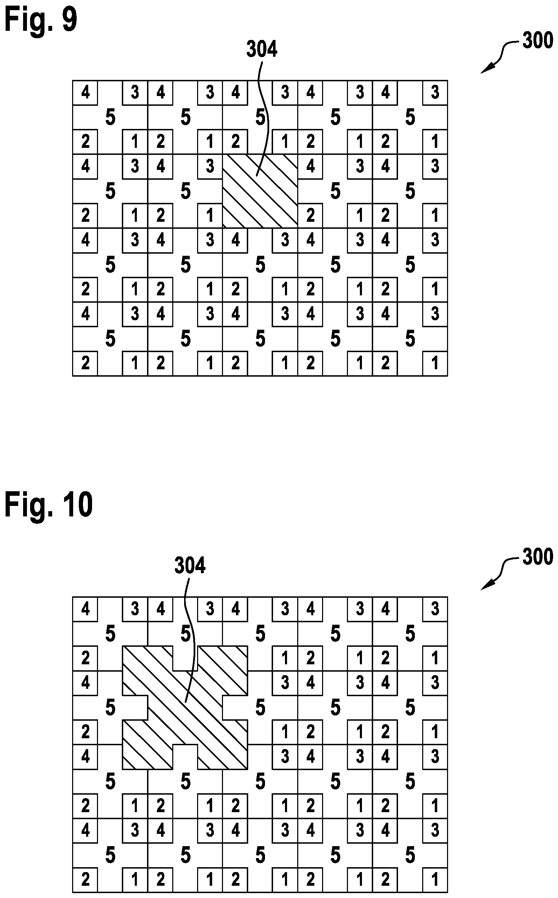

Fig. 9 zeigt eine schematische Darstellung eines Lichtsensormoduls 300 oder einer adressierten Makrozelle gemäß einem Ausführungsbeispiel. Das Lichtsensormodul 300 entspricht im Wesentlichen dem vorangehend anhand von Fig. 3 beschriebenen Lichtsensormodul. Gezeigt ist ein Lichtsensormodul mit einer adressierten minimalen Makrozelle 304, vorangehend auch Sensorzelle genannt. Gemäß einem Ausführungsbeispiel werden die Einzel-Zellen 1, 2, 3, 4, 5 auch als Sensorzelle bezeichnet, die gemeinsame Adressierung der 5 Zellen als Makrozelle, und die Zusammenschaltung von 17 Zellen als Superzelle bezeichnet, die auch als Optimal-Zelle bezeichnet wird.

Fig. 10 zeigt eine schematische Darstellung eines Lichtsensormoduls 300 oder einer adressierten Makrozelle gemäß einem Ausführungsbeispiel. Im Unterschied zu Fig. 9 ist hier die Adressierung einer optimalen Fünf-Kanal-Makrozelle 304 gezeigt. Die Makrozelle 304 wird auch als Superzelle bezeichnet, womit verbunden ist, dass bis zu 17 Einzelzellen berücksichtigt werden. Diese Adressierung ist etwas aufwendiger, erlaubt aber die volle Rekonstruktion von vier Eigenschaftskanälen und eines Luminanzkanals bei minimalem Unschärfekreis. Fig. 10 gibt das Adressierungsmuster einer optimalen Makrozelle wieder, wie sie beispielsweise in Fig. 7 gezeigt ist. In diesem Modus sollten die Sensorzellen entweder ladungszerstörungsfrei ausgelesen werden oder aber das digitalisierte Signal sollte für drei Zeilen zwischengespeichert werden, um dann eine ideale Rekonstruktion aus 17 Abtastwerten für jeden Makrobildpunkt zu ermöglichen.

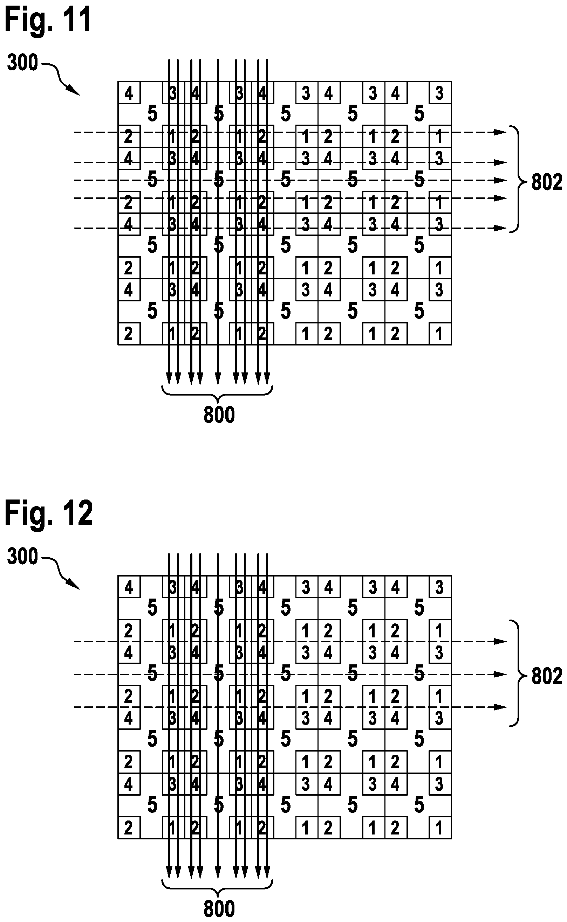

Das dafür erforderliche Adressierungsschema ist in Fig. 11 gezeigt.

Fig. 11 zeigt eine schematische Darstellung eines Lichtsensormoduls 300 oder eines Adressierungsschemas für eine Adressierung einer Superzelle mit überlappender Adressierung der Satellitenzellen gemäß einem Ausführungsbeispiel. Im Unterschied zu Fig. 8 umfasst das in Fig. 11 gezeigte Adressierungsschema für eine Fünf-Kanal-Anordnung fünf Auswahlleitungen 802 mit geringer Eingangslast und zweimal acht Leseleitungen 800. Zur besseren Übersichtlichkeit sind nicht alle Leseleitungen 800 dargestellt.

Bei dieser Adressierung werden gleichartige Zellen bereits auf der Leseleitung gemischt, da nur eine Leseleitung pro Spalte und Zelltyp zur Verfügung steht. Daraus ergibt sich eine effiziente Struktur aber eingeschränkte Nachbearbeitungsmöglichkeit.

Fig. 12 zeigt eine schematische Darstellung eines Lichtsensormoduls 300 gemäß einem Ausführungsbeispiel. Im Unterschied zu Fig. 11 zeigt Fig. 12 ein Adressierungsschema für eine Fünf-Kanal-Anordnung mit drei Auswahlleitungen 802, die jeweils Vierer-Cluster adressieren.

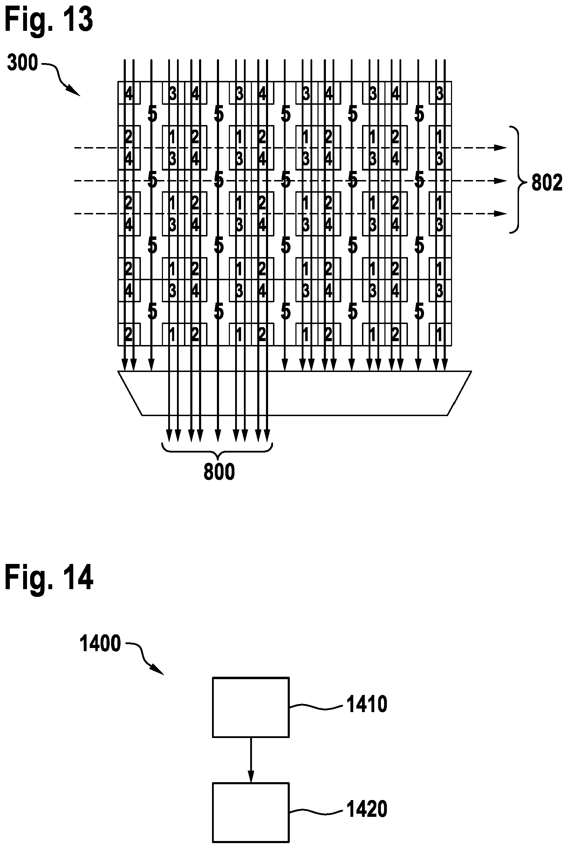

Fig. 13 zeigt eine schematische Darstellung eines Lichtsensormoduls 300 gemäß einem Ausführungsbeispiel. Hierbei werden beispielsweise 17 Leseleitungen aus n Leseleitungen 800 zu einem Zeitpunkt T0 ausgewertet. Die zum Zeitpunkt T0 adressierten Auswahlleitungen 802 selektieren parallel die Zusatzpixel 1, 2, 3, 4 der jeweiligen Sensorzellen.

Fig. 14 zeigt ein Ablaufdiagramm eines Verfahrens 1400 gemäß einem Ausführungsbeispiel. Das Verfahren 1400 zum Betreiben eines Lichtsensormoduls, etwa eines vorangehend anhand der Figuren 3 bis 13 beschriebenen Lichtsensormoduls, kann beispielsweise unter Verwendung einer vorangehend anhand der Figuren 4 bis 13 beschriebenen Signalverarbeitungseinheit durchgeführt werden. Hierbei werden in einem Schritt 1410 die Sensorpixel der in Spalten und Zeilen angeordneten Sensorzellen über eine oder mehrere Auswahlleitungen zeilenweise ausgewählt. In einem Schritt 1420 werden ansprechend auf das Auswählen im Schritt 1410 die Sensorsignale der ausgewählten Sensorpixel über eine oder mehrere Leseleitungen, durch die die ausgewählten Sensorpixel spaltenweise miteinander verbunden sind, ausgelesen. Gemäß einem Ausführungsbeispiel werden die Sensorsignale unterschiedlicher Sensorpixel, insbesondere der Sensorpixel eine Makro- oder Superzelle, hierbei im Wesentlichen zeitgleich ausgelesen.

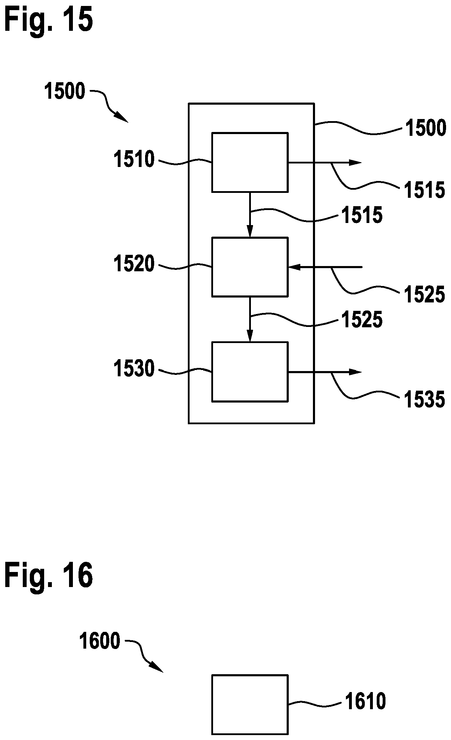

Fig. 15 zeigt eine schematische Darstellung einer Vorrichtung 1500 gemäß einem Ausführungsbeispiel. Beispielsweise kann die vorangehend anhand der Figuren 4 bis 14 beschriebene Signalverarbeitungseinheit eine Komponente der Vorrichtung 1500 sein. Die Vorrichtung 1500 umfasst eine Auswähleinheit 1510, die ausgebildet ist, um durch Ausgeben eines entsprechenden Auswahlsignals 1515 die auszulesenden Sensorpixel des Lichtsensormoduls über die entsprechenden Auswahlleitungen zeilenweise auszuwählen. Eine Ausleseeinheit 1520 ist ausgebildet, um ansprechend auf das Auswählen die jeweiligen Sensorsignale 1525 der ausgewählten Sensorpixel über die entsprechenden Leseleitungen auszulesen. Eine optionale Generierungseinheit 1530 ist ausgebildet, um unter Verwendung der Sensorsignale 1525 ein Bildsignal 1535 ohne Zwischenspeicherung der Sensorsignale 1525 zu generieren.

Fig. 16 zeigt ein Ablaufdiagramm eines Verfahrens 1600 gemäß einem Ausführungsbeispiel. Das Verfahren 1600 zum Herstellen eines Lichtsensormoduls, etwa eines vorangehend anhand der Figuren 3 bis 15 beschriebenen Lichtsensormoduls, umfasst einen Schritt 1610, in dem aus der Sensorlage mit den Sensorzellen und der Signalverarbeitungslage mit der Signalverarbeitungseinheit ein Lagenverbund gebildet wird, etwa in Stacked-Die-Technologie. Hierbei werden die Sensorpixel der Sensorzellen der Sensorlage in Spalten und Zeilen zueinander angeordnet. Ferner werden die Sensorpixel einer jeden Spalte über zumindest eine je einer anderen Lichteigenschaft zugeordnete Leseleitung elektrisch leitfähig mit der Signalverarbeitungseinheit verbunden und die Sensorpixel einer jeden Zeile über zumindest eine Auswahlleitung elektrisch leitfähig mit der Signalverarbeitungseinheit verbunden.

Nachfolgend werden verschiedene Ausführungsbeispiele des hier vorgestellten Ansatzes nochmals mit anderen Worten beschrieben.

Eines der Zusatzpixel 1 bis 4 trägt beispielsweise einen diagonal nach rechts geneigten Pol-Filter. Die Anordnung ermöglicht es, parallel zu einer Fahrbahnoberfläche oder parallel zu einer senkrechten Gebäudefassade polarisiertes Licht auszublenden.

Gemäß einem weiteren Ausführungsbeispiel ist eines der Sensorpixel als analoge lokale Zellen-Speicherkapazität ausgeführt. Dadurch kann ein Dynamikbereich eines der Signale vergrößert werden.

Eines der Sensorpixel kann ausgebildet sein, um Signale aus angrenzenden Sensorpixeln weiterzuleiten.

Die Signalverarbeitungseinheit ist beispielsweise ausgebildet, um die Zusatzpixel 1 bis 4 zeitlich verschoben gegenüber den Hauptpixeln 5 auszulesen. Die Zeitverschiebung wird beispielsweise zur Bestimmung der Modulation einer "Weltbeleuchtung" genutzt. Dazu wird die Differenz der rekonstruierten Luminanzsignale aus den zwei zeitlich versetzten Abtastzeitpunkten genutzt.

Optional ist die Signalverarbeitungseinheit ausgebildet, um eine Phasenverschiebung zwischen den Arrays des Hauptpixels 5 und der Zusatzpixel 1 bis 4 situationsbedingt einzustellen, etwa um die Auswirkung von modulierter Beleuchtung (Netzfrequenz 50/60 Hertz) zu verringern.

Der hier beschriebene Ansatz bringt folgende Vorteile mit sich.

Die Detektion unterschiedlicher Lichteigenschaften wie Luminanz, Farbe oder weitere nicht sichtbare Spektralkanäle oder Polarisation erfolgt zeitlich parallel und örtlich symmetrisch um einen großen und sensitiven Luminanzsensorpunkt als Hauptpixel 5 und kann diesem zugewiesen werden. Damit können bis zu fünf Merkmale mit einer Sensorzelle erfasst werden.

Durch eine geeignete Zusammenfassung der Lichtmerkmale, bspw. in einem vorgeschalteten programmierbaren Verknüpfungsnetzwerk zur Verarbeitung von einfach, Makro und Superzellen-Informationen, kann die Menge der Daten, die von einer hochaufgelösten Sensorzelle zur Signalverarbeitungseinheit, etwa einer nachgeschalteten Computer-Vision-Verarbeitungseinrichtung, übertragen werden, reduziert werden.

Die Detektion der Lichteigenschaften wird beispielsweise symmetrisch zum Intensitätssignal gemessen und kann etwa als Lichtkomponente dem zentralen Intensitätswert zugeordnet werden. Dabei kann bei geeigneter Auswertung die spektrale Verteilung aus zwei bis vier bandbegrenzten Spektralkanälen in Relation zu dem breitbandigen Signal gewonnen werden.

Durch geeignete Verteilung von on-chip-strukturierten, pixelselektiven Polarisationsfiltern kann insbesondere aus den breitbandig empfindlichen Sensorpixeln das Lichtmerkmal Polarisation extrahiert werden und eine Polarisationskarte der Umwelt erstellt werden. Dies ist besonders vorteilhaft für die Erkennung polarisierender Flächen wie etwa einer nassen Fahrbahn.

Die anhand von Fig. 4 beschriebene Zusammenfassung bzw. Gewichtung und Reduktion von Messdaten verschiedener Lichtsignaleigenschaften ist sinnvoll, wenn die Datenrate des folgenden Übertragungskanals begrenzt ist.

Üblicherweise würde die Datenrate der Digital-analog-Wandlung dem Eigenschaftssignal multipliziert mit der Anzahl der Lichtsensoren entsprechen. Es ist nun aber möglich, einige Lichteigenschaften bei bestimmten Anwendungen komprimiert abzuspeichern und damit mehrere Lichtsensormessungen in einen Abtastpunkt des Lichtsignals zu transformieren.

Dabei ist es beispielsweise möglich, die Lichtintensität in einem informationstheoretisch konstanten Signal-zu-Rausch-Verhältnis zu komprimieren.

Es ist allerdings auch möglich, die Farbinformation aus drei Lichtsensoren unterschiedlicher 12-Bit-Spektralkanäle in zwei je 8 Bit breite Kanäle zu codieren.

Je nach Signalqualität und anwendungsspezifischen Anforderungen ist es so möglich, die Bandbreite sensornah mit einfachen Rechenoperationen deutlich zu komprimieren.

Weitere Ausführungsbeispiele sind unter anderem die Nutzung eines Log-Lichtsensors zur Einstellung der Belichtungszeit der linearen Lichtsensoren und das Berechnen der Jones- oder Stokes-Parameter in niedriger Bit-Auflösung aus einigen Polarisationssensoren, die Berechnung spezifischer spektraler Kanäle wie etwa einer Chlorophyll-Detektion für vegetationsspezifische Merkmalsextraktionen (wenige Bits können ausreichen, beispielsweise zwei bis drei Bits für bis zu zehn Erkennungsstufen der Vegetation), die Berechnung von Infrarot- und UV-Kanälen sowie die Berechnung von Farbe.

Die Kernidee ist hier nach wie vor die möglichst sensornahe Reduktion der Datenrate unter Berücksichtigung der Anwendungsanforderungen und des Informationsgehaltes der verschiedenen Lichteigenschaftssensoren. Dabei reduziert sich die Datenrate pro Bildpunkt, etwa von 3 × 12 Bit für RGGB auf 12+8+8 Bit bei Intensität und u, v, als auch in der Menge der Bildpunkte, die erforderlich sind, um die räumlich aufgelöste Information widerzuspiegeln.

Hierzu ist das Lichtsensormodul 300 je nach Ausführungsbeispiel wie folgt realisiert.

Das Lichtsensormodul, auch Bildsensorarray genannt, weist eine Vielzahl von Einzelsensorelementen auf, vorangehend auch Sensorpixel genannt, die ausgebildet sind, um verschiedene Lichtmerkmale zu messen. Beispielsweise ist das Lichtsensormodul als Fünf-Kanal-Array mit vier symmetrisch um einen Luminanzkanal angeordneten Sensorpixeln ausgeführt. Hierbei sind etwa kleinere Sensorpixel zwischen größeren Sensorpixeln eingebettet. Die Sensorpixel sind getrennt oder zeitgleich zu einem zentralen Sensorpixel adressierbar. Die Sensorpixel können unterschiedlich ausgeprägte Pixeltransfercharakteristiken aufweisen. Beispielsweise sind die größeren Sensorpixel, etwa zur Intensitätsmessung, logarithmisch oder quasi logarithmisch ausgelegt und die kleineren Sensorpixel, etwa zur Farbmessung, linear ausgelegt oder umgekehrt. Die Makropixeldaten sind zur unmittelbaren Verarbeitung ohne Zwischenspeicher parallel auslesbar. Insbesondere ist das Lichtsensormodul in Stacked-Die-Technologie aufgebaut, um eine unmittelbare Verarbeitung von Sensorsignalen der einzelnen Sensorpixel zu einer verdichteten Komplexinformation zu ermöglichen, z. B. Pixel mit einer 12-Bit-Helligkeit, einer 14-Bit-Farbinformation, 2-Bit-Polarisationsinformation, 3-Bit-Infrarot- oder -UV-Anteil und einem 1-Bit-Modulatoinsindex, und dies bei gleicher optischer Ortsauflösung für die Luminanz und weitere optische Eigenschaften.

Der hier vorgestellte Ansatz ermöglicht somit eine skalierbare Auflösungssteuerung und eine ortsaufgelöste Erfassung verschiedenster Lichteigenschaften durch eine entsprechende Anordnung der Sensorzellen 304 und eine entsprechende Signalaufbereitung für eine rekonstruktionsgerechte Abtastung der Lichteigenschaften wie etwa Photonenenergie in Form verschiedener Wellenlängen oder Farben, Polarisation, lineare und logarithmische Intensität (über einen Dynamikumfang von mehr als sechs Dekaden) oder zeitlicher Intensitätsverlauf. Die Signalverarbeitungseinheit 402 dient hierbei insbesondere auch zur Informationsverdichtung.

Dabei ist eine Verteilung der Abtastpunkte so gewählt, dass bei möglichst kleinem optischem Unschärfekreis eine Abtastung mehrerer Lichteigenschaften möglich ist, die einem Ausgabebildpunkt zugeordnet werden können.

Ferner ermöglicht der hier beschriebene Ansatz eine variable Adressierung von Makropixeln 304, vorangehend auch Makro- oder Superzellen genannt, zur Verarbeitung von Signalgruppen mit unterschiedlichen Optimierungszielen wie etwa die Sampling-konforme Rekonstruktion eines hochaufgelösten Luminanzsignals oder mehrerer optischer Eigenschaften.

Durch den hier beschriebenen Ansatz kann etwa ein Sensor für maschinelles Sehen, der die Anforderungen bezüglich einer räumlichen Auflösung erfüllen soll, besonders effizient hinsichtlich einer Fläche, einer Bandbreite und eines Herstellungsaufwands realisiert werden.

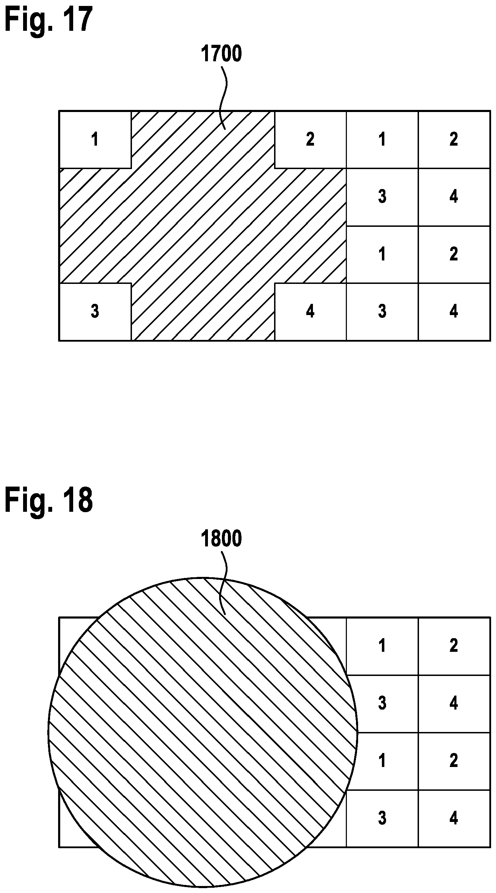

Fig. 17 zeigt eine schematische Darstellung eines minimalen Filterkerns 1700 in einem regelmäßigen 4-kanaligen Array für eine korrekte Abtastung einer VierKanal-Array-Anordnung mit der Ausdehnung 4r.

Fig. 18 zeigt eine schematische Darstellung eines minimalen Unschärfekreises 1800 einer abbildenden Optik, mit der die Abtastbedingung für alle Kanäle eingehalten werden kann.

Die Figuren 17 und 18 zeigen die (ungünstigen) Verhältnisse in nicht erfindungsgemäßen Anordnungen. Der Einsatz der gemäß dem hier beschriebenen Ansatz beschriebenen Struktur führt zu ähnlicher oder besserer Qualität bei kleinerer Gesamtfläche.

Im Folgenden werden weitere beispielhafte Sensor-Adressierungsstrukturen und -verfahren beschrieben, wodurch bei unterschiedlichen Sensor-Gitteranordnungen eine variable Zusammenfassung von Gruppen von Sensorpixeln erreicht wird. Diese Gruppierung und Basis-Nachverarbeitung ist im laufenden Betrieb einfach umkonfigurierbar, so dass je nach Situation unterschiedliche Abtasteigenschaften erzeugt werden können. Durch die Sensoradressierung und das angepasste Auslesen wird ein Bildsensor mit situativ anpassbarer Steuerung und Signalaufbereitung geschaffen. Durch die Anpassung des Abtastverhaltens des Sensors kann eine Verdichtung von abgetasteten Einzel-Signalen zu Informationen durchgeführt werden, die mit geringerer Bandbreite in einem Folge-Rechenwerk verarbeitet werden können.

Insbesondere ermöglichen die Adressierungsstrukturen, Sensorzellen mit unterschiedlichen Integrations- und Auslesephasengruppen zusammenzuschalten, aber auch Sensorpixel aus gleichen oder unterschiedlichen Kanälen (Zellen mit unterschiedlichen Lichtinformationen wie z.B. Photonennergie, Polarisation, Integrations-Phasenlage ...) zur Signalverbesserung zusammenzuschalten oder aus der Kombination der Signale neue komplex-Informationen zusammenzufassen.

Diese neuen Komplex-Informationen sind insbesondere Misch-Informationen die mit geringerer Datenbandbreite in einer Nachverarbeitungsstufe übertragen und verarbeitetet werden können.

Die Ausprägung der Adressierung ist dabei jeweils auf die zugrundeliegende Gitterform (orthogonal, hexagonal, Dreiecks-, Rhomben-Form) und die Anzahl der unterscheidbaren Sensor-Kanäle angepasst.

Die Zusammenschaltung mehrere gleichzeitig auszulesender Sensorzellen kann hierbei auf unterschiedliche Weise erfolgen:
- Analog in der Sensor oder Makrozelle (durch adressierbare Transfergates, welche die Sensorzellen direkt miteinander verbinden)
- Analog in der Sensor oder Makrozelle (durch Adressierung eines Transfergates, welches den Ladungstransport von einer Sensorzelle auf eine von mehreren Zellen gespeiste Kapazität ermöglicht)
- Auf der Leseleitung (indem ein Schalt-transistor Ausgangsverstärker der Zelle auf eine gemeinsame Leseleitung aufschaltet)
- Analog in einer Sample & Hold-Stufe
- Digital in einem digitalen Rechenwerk welches Signale einer Makrozelle als Eingang erhält und eine programmierbare / selektierbare Rechenoperation ausführt.

Die folgenden Sensor-Adressierungsstrukturen und Ansteuerungs-/ Auslesebeispiele werden anhand eines 5-Kanal Sensors 300 beschrieben. Sie können aber problemlos auf andere Sensortypen und Aufbauten übertragen werden.

Das 5-Kanal Design 300, welches in der Fig. 3 dargestellt ist, ist ein repetitives Pattern von Sensorzellen die bis zu 5 individuell unterschiedlich ausgelegte Sensorpixel -Typen erlaubt. Als Sensorpixel-Typen kommen bspw. folgende Möglichkeiten und deren Kombinationen in Frage:
1. Der große zentrale Sensorpixel (5 in Fig. 6 oder Fig. 7), könnte bspw. von folgenden Typ sein:
   a) HDR Lin Luminanz = z. B. ungeteilte PIN-diode mit großer Full-Well
   b) split linear Luminanz = 2 Teildioden, welche durch einen Schalter getrennt sind oder 1 Diode mit angeschlossener Transfer-Kapazität
   c) log Luminanz = Zelle im Photovoltaik-Modus
   d) lin/log Luminanz = Diode mit schaltbarem Zustand (siehe NIT)
2. Die periphere "Satelliten- Sensorpixel" bzw. Zusatzpixel (1, 2, 3, 4 in Fig. 6 oder Fig. 7) könnten von folgendem Typ sein:
   a) RBGC: rot, grün, blau, clear
   b) RGCNir: rot, grün, clear near infrared
   c) RBCpolhCpolv: rot, grün, clear horizontal polarisiert,clear vertikal polarisiert
   d) Oder jede Permutation aus den zuvor genannten Zell-Typen bzw. deren Derivaten.

Die in Fig. 6 dargestellte Sensorzelle 304, welche einen Ausschnitt aus der Sensoranordnung des in Fig. 3 dargestellten Sensors entspricht, wird im als Makrozelle bezeichnet. Die in Fig. 7 dargestellte Sensorzelle wird als Super Zelle bezeichnet. Sowohl Makro- als auch Superzelle wiederholen sich in regelmäßiger Weise bei Betrachtung der gesamten Sensoranordnung in Fig. 3. Die Makrozelle weist fünf unterschiedliche Sensorpixel auf. Die Super-Zelle wird aus insgesamt 17 Sensorpixeln gebildet. Falls die Sensorpixel derart ausgelegt sind, dass sie eine Rekonstruktion der Eigenschaft der mittig angeordneten Zelle 5 erlauben, beispielsweise eine Helligkeitsinformation, wird eine abtastkonforme Rekonstruktion von Ortsfrequenzen bis hinunter zum 1,5 fachen der Makrozellengröße erreicht.

Zur Auslesung des 5-Kanal Sensors 300 kommen mehrere Adressierungsarten in Betracht.

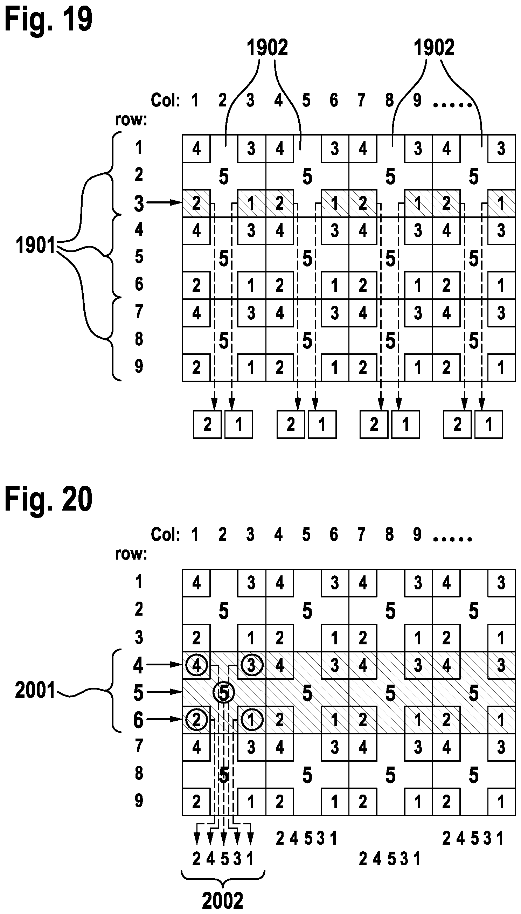

In Fig. 19 ist ein Adressierungsschema dargestellt, bei welchem jede Makrozelle nacheinander / zeitlich versetzt durch jeweils drei Adressleitungen 1901 erfasst wird, welche vertikal drei Teilbereiche der Makrozelle adressieren. Für die obersten Makrozellen 1902 sind dies entsprechend die obersten drei Zeilen. Die einfachste Adressierung ist die linear fortschreitende Adressierungen, die in diesem Beispiel zwei oder eine Zellenart erfasst.

Die Anzahl der adressierten Sensorpixel variiert je nach Zone. Zeilen 1 und 3 adressieren jeweils doppelt so viele Sensorpixel wie Zeile 2. Das Muster wiederholt sich jeweils nach 3 Zeilen, sprich Modulo 3.

Nach dem Auslesen von drei Zeilen kann die Berechnung einer Kombination aus den fünf Beiträgen einer Makrozelle begonnen werden. Nach fünf Zeilen kann die Berechnung der komplexwerte auf das Super-Zellen-Umfeld ausgeweitet werden. In diesem Modus werden pro Zeile und Makrozelle zeitgleich abwechselnd eine oder zwei Leseleitungen benötigt, um die Zelleninformation in die Signalaufbereitungseinheit zu transportieren. Zwei Leseleitung für die Zeilen 1, 3, 4, 6, 7, 9, ... und eine Leseleitung für die Zeilen 2, 5, 8, ....

In Fig. 20 ist ein weiteres Adressierungsschema dargestellt, bei welchem jede Makrozelle zeitgleich durch drei Adressleitungen 2001 adressiert wird. Jede Adressleitungen erfasst dabei einen der vertikalen drei Teilbereiche der Makrozelle, welche in Fig. 20 den Zeilen 4 bis 6 entsprechen.

Die Auslesung erfolgt über fünf parallele Leseleitungen 2002 pro Makrozelle, um die Zellen 1, 2, 3, 4, 5 einer Makrozelle separieren zu können, die in einer Spalte liegen. Die Adressierung springt Modulo 3, um jeweils drei Zeilen. Die Daten der fünf Einzelzellen 1, 2, 3, 4, 5 der Makrozellen werden durch fünf parallele Leitungen 2002 zu der Signalaufbereitungseinheit geleitet. Die Berechnung einer Kombination aus den fünf Beiträgen einer Makrozelle kann unmittelbar, ohne Zwischenspeicherung der ausgelesenen Daten erfolgen.

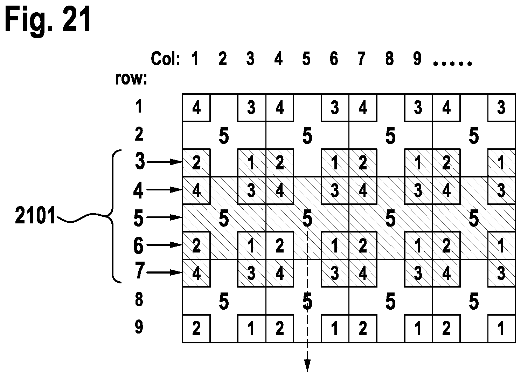

In Fig. 21 ist ein weiteres Adressierungsschema dargestellt, bei welchem jede Superzelle durch zeitgleich fünf Adressleitungen 2101 adressiert wird. Jede Adressleitung erfasst dabei einen der fünf Teilbereiche/Sensorpixel aus einer Makrozelle und jeweils zwei Teilbereiche/Sensorpixel aus der darüber und der darunter liegenden Nachbar-Makrozelle. In Fig. 21 sind dies die Zeilen 3 bis 7.

Bei der Adressierung werden jeweils drei neue Adressleitungen aktiviert und zwei bereits adressierte Reihen beibehalten. In Fig. 21 ist die Adressierung der Superzellen um Zeile 5 adressiert (jeweils 2 Zeilen über und unter Zeile 5). Um die nächste Reihe mit Superzellen zu adressieren entfällt die Selektion der Zeilen 3 bis 5 und es kommt die Adressierung der Zeilen 8 bis 10 hinzu.

Die Werte einer Superzelle werden über neun Leseleitungen pro Superzelle ausgelesen, welche die schwarz markierten Sensorpixel der ersten drei Spalten in den Reihen 3 bis 7 (Fig. 21) auslesen. Für die Berechnung von Superzellen-Kombinationen ist es erforderlich jeweils vier Leitungen der beiden angrenzenden Nachbar-Zellen in den gleichen Zeilen einzubeziehen. Hierfür ist eine Zusatzstruktur zur Speicherung (digitales Signal) oder Pufferung (bei analogen Signalen) erforderlich, um die überlappenden Signalanteile beiden Zellen zur Verfügung zu stellen. Die Berechnung der Superzellen-Inhalte erfolgt aus der Kombination aus den 17 Beiträgen der Einzelnen-Sensorpixel einer Superzelle.

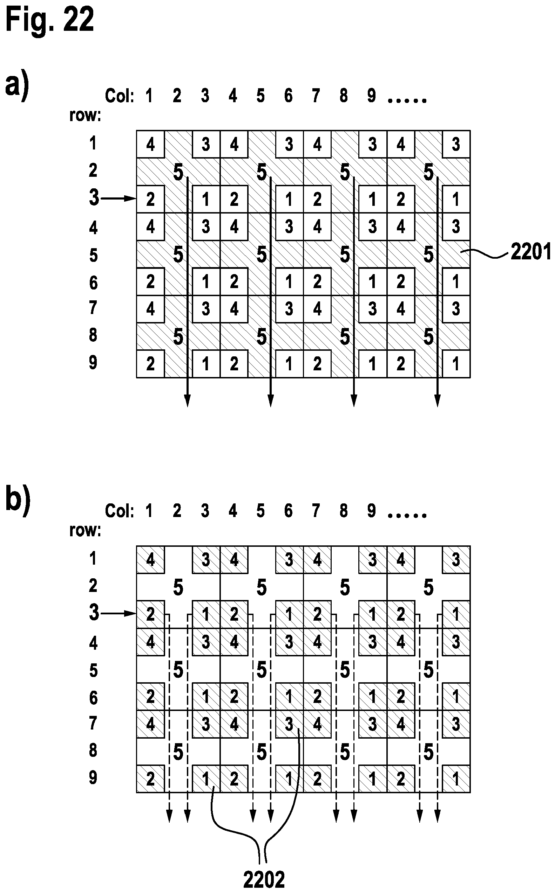

In Fig. 22 ist ein weiteres Adressierungsschema dargestellt, bei welchem definierte Pixelgruppen und/oder Zellenkombinationen zeitversetzt ausgelesen werden. Hierbei kann der gesamte Bildsensor bzw. alle verfügbaren Sensorpixel beispielsweise in zwei oder mehrere Pixelgruppen oder Zellkombinationen aufgeteilt werden. Von Vorteil ist es, wenn die Pixelgruppen oder Zellgruppen eine gleiche Eigenschaft der detektierten Strahlung erfassen können, bspw. einen Luminanzwert. Dies ist durch eine entsprechende Auswahl der einzelnen Sensorpixel umsetzbar.

Bei der dieser sog. Adressierung im Phase-Shift-Modus, werden jeweils die in einer Phase zusammengefassten Pixelgruppen oder Sensorzellen durch die Adressierung erreicht. Hierbei ist es vorteilhaft, jeweils adressierte Pixelgruppen oder Sensorzellen symmetrisch zu arrangieren. Für diese Adressierungsschema wird der 5-Kanal-Sensor 300 in zwei Sensorzellgruppen unterteilt, in diesem Fall "Phase1"-Zellen 2201 und "Phase2"-Zellen 2202, welche jeweils in Fig. 22 a) und b) schwarz markiert dargestellt sind.

Zwischen der Adressierung der "Phase1"-Zellen 2201 und der "Phase2"-Zellen 2202 erfolgt bspw. eine Taktverschiebung von Adresstakten um eine programmierbare Zeit T_{delay}, welche z. B. im Bereich von wenigen Zeilenzeiten (Zeit zum Auslesen einer Zeile) bis zu mehreren 100 Zeilenzeiten groß sein kann. Hierdurch werden Signale erzeugt, die das gleiche Makro-Zellengebiet abdecken aber zu unterschiedlichen Zeitpunkten abgetastet wurden.

Da je nach Auslegung der einzelnen Sensorpixel aus beiden Sensorzellengruppen z. B. ein Luminanzsignal ermittelt werden kann, ist es möglich, ein zeitliches Ableitungssignal zu erzeugen, welches nicht von der Framerate des Sensors 300 abhängig ist, sondern von einem Delay-Glied, welches die Zeit T_{delay} festlegt, welche zwischen der Abtastung der "Phase1"-Zellen 2201 und der "Phase2"-Zellen 2202 liegt.

Es ist auch möglich, die Zeit T_{delay} während des Betriebs des Sensors 300 zu verändern, sodass unterschiedliche Verzögerungen zwischen den Abtastungen der "Phase1"-Zellen 2201 und der "Phase2"-Zellen 2202 liegen. Hierdurch kann gewährleistet werden, dass bspw. pulsierende Lichtzeichen erkannt werden. Diese könnten ohne die zeitlich verzögerte Abtastung aufgrund der begrenzten Auslesegeschwindigkeiten des Bildsensors 300 oder einer ungünstiger Phasenlage zwischen Sensorabtastung und der Frequenz der Lichtquelle nicht erfassbar sein.

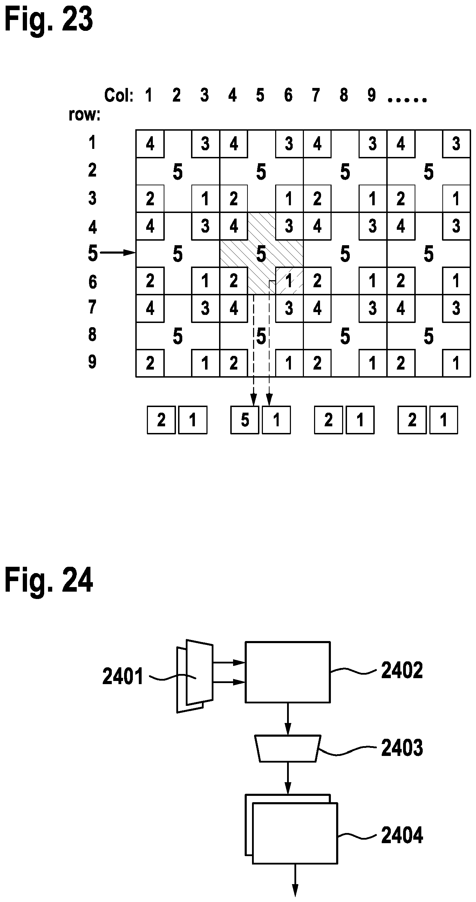

In Fig. 23 ist ein weiteres Adressierungsschema dargestellt, bei welchem die Adressierungsleitungen von zwei oder mehreren Sensorpixel elektrisch miteinander verbunden werden.

In Fig. 23 werden hierfür pro Makrozelle jeweils die Adressleitungen der Sensorpixel 5 der Sensorpixel 1 miteinander verbunden. Die kombinierten Sensorpixel werden als Split-Pixel bezeichnet, die in diesem Ausführungsbeispiel mit einzelnen Sensorpixel und/oder Sensorzellen kombiniert sind. Werden diese festverdrahteten Split-Pixel aus der Adressierung der restlichen Zeilenelemente gelöst, dann sind die Split-Pixel-Elemente, bzw. die mittels der Split-Pixel ausgelesenen Signale z. B. für hochdynamische Sensor-Zellen gemeinsam mit Einfachzellen und/oder Sensorpixeln bzw. deren Signalen kombinierbar.

In Fig. 24 ist eine beispielhafte Anordnung dargestellt, mit welcher die Adressierungs- und Ausleseschemas hardwareseitig umgesetzt werden können. Dieser hier dargestellte mechanische Baustein einer Kamera kann bevorzugt mittels der "stacked die"-Technologie umgesetzt werden.

Der Aufbau besteht aus einem Array aus Sensorzellen 2402, welche von einem programmierbaren Adressmultiplexer 2401 adressiert werden. Mittels des programmierbaren Adressmultiplexer 2401 können beliebige Sensorpixel oder Sensorzellen aus allen vorhandenen Sensorpixeln ausgewählt werden und zu unterschiedlich Zeiten adressiert werden. Sowohl die adressierten Sensorpixel oder Sensorzellen, als auch die Zeiten, zu welchen diese adressiert werden, können beliebig variiert und/oder einprogrammiert werden. Mittels eines Leseleitungsmultiplexers 2403 werden bestimmte Sensorpixel oder Sensorzellen zu festgelegten Zeiten ausgelesen und die ausgelesenen Signale auf eine beliebige Anzahl von Signalaufbereitungsnetzwerken/ Signalaufbereitungseinheiten 2404 verteilt. Diese Signalaufbereitungsnetzwerke 2404 können programmierbar oder trainierbar sein. Es können auch mehrere dieser Signalaufbereitungsnetzwerke 2404 nacheinander oder parallel von dem Leseleitungsmultiplexer 2403 mit ausgelesenen Signalen/Informationen versorgt werden. Mittels dieser Signalaufbereitungsnetzwerke 2404 ist eine Verarbeitung von einfach, Makro und Superzellen-Informationen möglich. Durch diese Signalaufbereitungsnetzwerke 2404 ist es möglich, ein zeitlich und/oder räumlich gefiltertes und anwendungsbezogen kombiniertes Signal mit geringer Bandbreite zu erzeugen.

Die Multiplexer der Adressierungseinheit 2401 werden bevorzugt als ladbare Schieberegister ausgeführt. Diese können bspw. mit einem Muster geladen werden, welches anschließend zyklisch durchlaufen wird, bis ein anderes Adressierungspattern benötigt und/oder eingeladen wird. Die Adressierungs-2401 und Signalaufbereitungseinheit 2404 werden durch einen ebenfalls mitintegrierten und nicht dargestellten Mikrocontroller gesteuert.

In den Signalaufbereitungseinheiten 2404 können auch bereits Misch-Informationen verarbeitet und erzeugt werden, bspw. integrierte Mischsignale aus Einzelkanälen, wie
(Luminanz) + (polgefilterte Luminanz) oder
(Luminanz) - (polgefilterter Luminanz), oder
(Luminanz im transparenten Kanal (Sensorpixel 5 in Fig. 6)) - (ermittelte Luminanz aus der Summe mehreren Spektralkanäle (Sensorpixel 1, 2, 3, 4 in Fig. 6)).

Durch die Anwendung der beschrieben Adressierungs- und Ausleseschemas ergibt sich eine Vielzahl an Vorteilen. Basis-Signale, die in großer Zahl und mit hoher Abtastrate erzeugt werden können Situationsangepasst und unmittelbar im Sensor verdichtet werden, sodass der Informationsgehalt an die jeweilige Situation und Erkennungsaufgabe angepasst und die Datenrate zur Nachverarbeitungseinheit reduziert werden kann. Zudem ist eine zeitliche und örtliche Tiefpassfilterung von abgetasteten Signalen möglich. Des Weiteren können mittels der Schemas und dem zugehörigen Aufbau Kombinations-Signale erzeugt werden, die eine höhere Relevanz für einen anschließenden Klassifikationsprozess enthalten. Der vorgestellte Aufbau enthält zudem "programmierbare, trainierbar oder lernende" Elemente in der Signalaufbereitungseinheit 2404, die auf die Aufbereitung von Signalen einer Makro-oder Superzelle angepasst sind.

Ein weiterer wesentlicher Vorteil, der durch den Aufbau und die Adressierungs-und Ausleseschemas entsteht, ist die Verdichtung von Informationen am Entstehungsort / in der Signalaufbereitungseinheit 2404. Hierdurch können die Übertragungsraten deutlich reduziert werden.

## Patentansprüche

1. Lichtsensormodul (300) mit folgenden Merkmalen:
einer Sensorlage (302) mit einer Mehrzahl von Sensorzellen (304), wobei die Sensorzellen (304) je zumindest zwei Sensorpixel (1, 2, 3, 4, 5) zum Erfassen je einer anderen Lichteigenschaft aufweisen, wobei unter einer Lichteigenschaft eine Wellenlänge, eine Farbe, eine Polarisation, eine lineare und logarithmische Intensität oder ein zeitlicher Intensitätsverlauf verstanden wird, und wobei die Sensorpixel (1, 2, 3, 4, 5) in Spalten und Zeilen angeordnet sind; und
einer Signalverarbeitungseinheit (402) zum Verarbeiten von Sensorsignalen (1525) der Sensorpixel (1, 2, 3, 4, 5), wobei die Sensorpixel (1, 2, 3, 4, 5) einer jeden Spalte über zumindest eine je einer anderen Lichteigenschaft zugeordnete Leseleitung (800) elektrisch leitfähig mit der Signalverarbeitungseinheit (402) verbunden sind und die Sensorpixel (1, 2, 3, 4, 5) einer jeden Zeile über zumindest eine Auswahlleitung (802) elektrisch leitfähig mit der Signalverarbeitungseinheit (402) verbunden sind, wobei die Signalverarbeitungseinheit (402) ausgebildet ist, um die Sensorpixel (1, 2, 3, 4, 5) zum Auslesen über die Leseleitung (800) zeilenweise über die Auswahlleitung (802) auszuwählen,
**dadurch gekennzeichnet, dass**
jede der Sensorzellen (304) mit einem Hauptpixel (5) und zumindest zwei Zusatzpixeln (1, 2, 3, 4) als den Sensorpixeln (1, 2, 3, 4, 5) ausgebildet ist, wobei eine Fläche des Hauptpixels (5) größer ist als eine jeweilige Fläche eines Zusatzpixels (1, 2, 3, 4), wobei die zumindest zwei Zusatzpixel (1, 2, 3, 4) symmetrisch um das Hauptpixel (5) angeordnet sind.

2. Lichtsensormodul (300) gemäß Anspruch 1, bei dem jede der Sensorzellen (304) mit dem Hauptpixel (5) und vier Zusatzpixeln (1, 2, 3, 4) als den Sensorpixeln (1, 2, 3, 4, 5) ausgebildet ist, wobei die vier Zusatzpixel (1, 2, 3, 4) symmetrisch um das Hauptpixel (5) angeordnet sind.

3. Lichtsensormodul (300) gemäß einem der vorangegangenen Ansprüche, bei dem das Hauptpixel (5) als ein die Sensorzelle (304) in vier Quadranten aufteilendes Kreuz ausgeformt ist, wobei in jedem der vier Quadranten je eines der Zusatzpixel (1, 2, 3, 4) angeordnet ist.

4. Lichtsensormodul (300) gemäß einem der vorangegangenen Ansprüche, bei dem das Hauptpixel (5) ausgebildet ist, um eine Helligkeit, insbesondere eine breitbandige Helligkeit zu erfassen.

5. Lichtsensormodul (300) gemäß einem der vorangegangenen Ansprüche, mit einer Signalverarbeitungslage (400), wobei die Signalverarbeitungseinheit (402) in der Signalverarbeitungslage (400) angeordnet ist, wobei die Signalverarbeitungslage (400) und die Sensorlage (302) in einem Verfahren der Halbleitertechnik zu einem Lagenverbund miteinander kombiniert sind.

6. Lichtsensormodul (300) gemäß einem der vorangegangenen Ansprüche, bei dem die Sensorpixel (1, 2, 3, 4, 5) in zumindest einer ersten Zeile und einer zweiten Zeile angeordnet sind, wobei die erste Zeile eine größere Anzahl von über die Auswahlleitung (802) auswählbarer Sensorpixel (1, 2, 3, 4, 5) als die zweite Zeile aufweist, und/oder in zumindest einer ersten Spalte und einer zweiten Spalte angeordnet sind, wobei die erste Spalte eine größere Anzahl von über die Leseleitung (800) auslesbarer Sensorpixel (1, 2, 3, 4, 5) als die zweite Spalte aufweist.

7. Verfahren (1400) zum Betreiben eines Lichtsensormoduls (300) gemäß einem der vorangegangenen Ansprüche, wobei das Verfahren (1400) folgende Schritte umfasst:
Zeilenweises Auswählen (1410) von Sensorpixeln (1, 2, 3, 4, 5) über die Auswahlleitung (802); und
Auslesen (1420) von Sensorsignalen (1525) der über die Auswahlleitung (802) ausgewählten Sensorpixel (1, 2, 3, 4, 5) über die Leseleitung (800).

8. Verfahren (1400) gemäß Anspruch 7, bei dem im Schritt des Auslesens (1420) die Sensorzellen (304) im Wesentlichen zeitgleich ausgelesen werden.

9. Verfahren (1400) gemäß Anspruch 7 oder 8, mit einem Schritt des Generierens eines Bildsignals (1535) unter Verwendung der Sensorsignale (1525), insbesondere wobei das Bildsignal (1535) ohne Zwischenspeicherung der Sensorsignale (1525) generiert wird.

10. Computerprogramm umfassend Befehle, die bewirken, dass die Signalverarbeitungseinheit (402) des Lichtsensormoduls (300) gemäß einem der Ansprüche 1 bis 6 die Verfahrensschritte nach einem der Ansprüche 7 bis 9 auszuführt.

11. Computerlesbares Medium, auf dem das Computerprogramm nach Anspruch 10 gespeichert ist.

## Claims

1. Light sensor module (300) having the following features:
a sensor layer (302) having a plurality of sensor cells (304), wherein the sensor cells (304) each have at least two sensor pixels (1, 2, 3, 4, 5) each for capturing a different light property, wherein a light property is understood as meaning a wavelength, a colour, a polarization, a linear and logarithmic intensity or a temporal intensity profile, and wherein the sensor pixels (1, 2, 3, 4, 5) are arranged in columns and rows; and
a signal processing unit (402) for processing sensor signals (1525) from the sensor pixels (1, 2, '3, 4, 5), wherein the sensor pixels (1, 2, 3, 4, 5) of each column are connected to the signal processing unit (402) in an electrically conductive manner via at least one read line (800) each assigned to a different light property, and the sensor pixels (1, 2, 3, 4, 5) of each row are connected to the signal processing unit (402) in an electrically conductive manner via at least one selection line (802),
wherein the signal processing unit (402) is designed to use the selection line (802) to select the sensor pixels (1, 2, 3, 4, 5) in a row-by-row manner for reading via the read line (800),
**characterized in that**
each of the sensor cells (304) is formed with a main pixel (5) and at least two additional pixels (1, 2, 3, 4) as the sensor pixels (1, 2, 3, 4, 5), wherein an area of the main pixel (5) is greater than a respective area of an additional pixel (1, 2, 3, 4),
wherein the at least two additional pixels (1, 2, 3, 4) are arranged symmetrically around the main pixel (5).

2. Light sensor module (300) according to Claim 1, in which each of the sensor cells (304) is formed with the main pixel (5) and four additional pixels (1, 2, 3, 4) as the sensor pixels (1, 2, 3, 4, 5), wherein the four additional pixels (1, 2, 3, 4) are arranged symmetrically around the main pixel (5).

3. Light sensor module (300) according to one of the preceding claims, in which the main pixel (5) is formed as a cross dividing the sensor cell (304) into four quadrants, wherein one of the additional pixels (1, 2, 3, 4) is arranged in each of the four quadrants.

4. Light sensor module (300) according to one of the preceding claims, in which the main pixel (5) is designed to capture a brightness, in particular a broadband brightness.

5. Light sensor module (300) according to one of the preceding claims, having a signal processing layer (400), wherein the signal processing unit (402) is arranged in the signal processing layer (400), wherein the signal processing layer (400) and the sensor layer (302) are combined with one another in a semiconductor technology method to form a layer composite assembly.

6. Light sensor module (300) according to one of the preceding claims, in which the sensor pixels (1, 2, 3, 4, 5) are arranged in at least a first row and a second row, wherein the first row has a greater number of sensor pixels (1, 2, 3, 4, 5) which can be selected via the selection line (802) than the second row, and/or are arranged in at least a first column and a second column, wherein the first column has a greater number of sensor pixels (1, 2, 3, 4, 5) which can be read via the read line (800) than the second column.

7. Method (1400) for operating a light sensor module (300) according to one of the preceding claims, wherein the method (1400) comprises the following steps of:
selecting (1410) sensor pixels (1, 2, 3, 4, 5) in a row-by-row manner via the selection line (802); and
using the read line (800) to read (1420) sensor signals (1525) from the sensor pixels (1, 2, 3, 4, 5) selected via the selection line (802).

8. Method (1400) according to Claim 7, in which the sensor cells (304) are read substantially at the same time in the reading step (1420).

9. Method (1400) according to Claim 7 or 8, having a step of generating an image signal (1535) using the sensor signals (1525), in particular wherein the image signal (1535) is generated without buffering the sensor signals (1525).

10. Computer program comprising instructions which cause the signal processing unit (402) of the light sensor module (300) according to one of Claims 1 to 6 to carry out the method steps according to one of Claims 7 to 9.

11. Computer-readable medium on which the computer program according to Claim 10 is stored.

## Revendications

1. Module capteur de lumière (300), ayant les caractéristiques suivantes :
une couche de capteur (302) comprenant une pluralité de cellules de capteur (304), les cellules de capteur (304) possédant chacune au moins deux pixels de capteur (1, 2, 3, 4, 5) destinés à capter chacun une propriété de lumière différente, une propriété de lumière désignant une longueur d'onde, une couleur, une polarisation, une intensité linéaire et logarithmique ou une courbe d'intensité dans le temps, et les pixels de capteur (1, 2, 3, 4, 5) étant disposés en colonnes et en lignes ; et une unité de traitement de signal (402) destinée à traiter des signaux de capteur (1525) des pixels de capteur (1, 2, 3, 4, 5), les pixels de capteur (1, 2, 3, 4, 5) de chaque colonne étant reliés de manière électriquement conductrice à l'unité de traitement de signal (402) par le biais d'au moins une ligne de lecture (800) respectivement associée à une autre propriété de lumière, et les pixels de capteur (1, 2, 3, 4, 5) de chaque ligne étant reliés de manière électriquement conductrice à l'unité de traitement de signal (402) par le biais d'au moins une ligne de sélection (802), l'unité de traitement de signal (402) étant configurée pour sélectionner ligne par ligne par le biais de la ligne de sélection (802) les pixels de capteur (1, 2, 3, 4, 5) à lire par le biais de la ligne de lecture (800), **caractérisé en ce que**
chacune des cellules de capteur (304) est configurée avec un pixel principal (5) et au moins deux pixels supplémentaires (1, 2, 3, 4) en tant que pixels de capteur (1, 2, 3, 4, 5), une surface du pixel principal (5) étant supérieure à une surface respective d'un pixel supplémentaire (1, 2, 3, 4), les au moins deux pixels supplémentaires (1, 2, 3, 4) étant disposés symétriquement autour du pixel principal (5).

2. Module capteur de lumière (300) selon la revendication 1, avec lequel chacune des cellules de capteur (304) est configurée avec le pixel principal (5) et quatre pixels supplémentaires (1, 2, 3, 4) en tant que pixels de capteur (1, 2, 3, 4, 5), les quatre pixels supplémentaires (1, 2, 3, 4) étant disposés symétriquement autour du pixel principal (5).

3. Module capteur de lumière (300) selon l'une des revendications précédentes, avec lequel le pixel principal (5) est façonné en tant que croix qui divise la cellule de capteur (304) en quatre quadrants, l'un des pixels supplémentaires (1, 2, 3, 4) étant respectivement disposé dans chacun des quatre quadrants.

4. Module capteur de lumière (300) selon l'une des revendications précédentes, avec lequel le pixel principal (5) est configuré pour détecter une luminosité, notamment une luminosité à large bande.

5. Module capteur de lumière (300) selon l'une des revendications précédentes, comprenant une couche de traitement de signal (400), l'unité de traitement de signal (402) étant disposée dans la couche de traitement de signal (400), la couche de traitement de signal (400) et la couche de capteur (302) étant combinées l'une à l'autre en une combinaison de couches dans un procédé de la technologie des semiconducteurs.

6. Module capteur de lumière (300) selon l'une des revendications précédentes, avec lequel les pixels de capteur (1, 2, 3, 4, 5) sont disposés en au moins une première ligne et une deuxième ligne, la première ligne possédant un plus grand nombre de pixels de capteur (1, 2, 3, 4, 5) pouvant être sélectionnés par le biais de la ligne de sélection (802) que la deuxième ligne, et/ou sont disposés en au moins une première colonne et une deuxième colonne, la première colonne possédant un plus grand nombre de pixels de capteur (1, 2, 3, 4, 5) pouvant être lus par le biais de la ligne de lecture (800) que la deuxième colonne.

7. Procédé (1400) pour faire fonctionner un module capteur de lumière (300) selon l'une des revendications précédentes, le procédé (1400) comprenant les étapes suivantes :
sélection (1410) ligne par ligne de pixels de capteur (1, 2, 3, 4, 5) par le biais de la ligne de sélection (802) ; et
lecture (1420), par le biais de la ligne de lecture (800), de signaux de capteur (1525) des pixels de capteur (1, 2, 3, 4, 5) sélectionnés par le biais de la ligne de sélection (802).

8. Procédé (1400) selon la revendication 7, avec lequel, à l'étape de lecture (1420), les cellules de capteur (304) sont lues sensiblement simultanément.

9. Procédé (1400) selon la revendication 7 ou 8, comprenant une étape de génération d'un signal d'image (1535) en utilisant les signaux de capteur (1525), le signal d'image (1535) étant notamment généré sans mémorisation intermédiaire des signaux de capteur (1525).

10. Programme informatique, comprenant des instructions qui ont pour effet que l'unité de traitement de signal (402) du module capteur de lumière (300) selon l'une des revendications 1 à 6 exécute les étapes du procédé selon l'une des revendications 7 à 9.

11. Support lisible par ordinateur, sur lequel est enregistré le programme informatique selon la revendication 10.
